# NEW EUROPEAN PATENT SPECIFICATION

(11) **EP 0 091 094 B2**
(45) Date of publication and mention of the opposition decision: **10.03.1993**
(45) Mention of the grant of the patent: 06.06.1990
(21) Application number: 83103196.8
(22) Date of filing: 30.03.1983
(51) Int. Cl.: H01L 29/743, H01L 29/72

(54) **Insulated gate rectifier with improved current-carrying capability**
Gleichrichter mit isoliertem Gate mit verbesserter Strombelastbarkeit
Redresseur à électrode de porte isolée ayant une caractéristique de transfert de courant améliorée

(30) Priority: 05.04.1982 US 365076
(43) Date of publication of application: 12.10.1983
(73) Proprietor: GENERAL ELECTRIC COMPANY, Schenectady New York 12305 (US)
(72) Inventor: Adler, Michael Stuart, Schenectady New York 12309 (US); Baliga, Bantval Jayant, Clifton Park New York 12065 (US)
(74) Representative: Kinne, Reinhard, Dipl.-Ing.

(56) References cited:
- EP-A- 0 014 435
- EP-A- 0 111 804
- FR-A- 2 488 046
- GB-A- 2 072 422
- IBM TECHNICAL DISCLOSURE BULLETIN, vol. 24, no. 9, February 1982, pages 4660-4661, New York, US; D.L.BERGERON: "Gate-controlled silicon-controlled rectifier cell"
- IEEE ELECTRON DEVICE LETTERS, vol. EDL-4, no. 3, March 1983, pages 63-65, IEEE, New York, US; J.P.RUSSELL et al.: "The COMFET-A new high conductance MOS-gated device"

## Description

The invention relates to an insulated gate rectifier according to the preamble of claim 1.

In the documents EP-A-0 014 435 and FR-A-2 486 046 conventional thyristors are described.

Document EP-A-0 014 435 discloses a thyristor to which a field effect transistor structure is adapted to facilitate the turn on of the thyristor, that is to achieve an almost powerless turn on of the thyristor, which can be carried out by semiconductor control circuits such as a micro-processor. By means of the control electrode of the field effect transistor structure a small gate current is controlled which turns on the thyristor. The field effect transistor structure embedded in the thyristor consists of parts of three thyristor layers, thereby forming a planar semiconductor structure in the upper region of the device. With respect to the doping concentrations and the mechanical dimensions both the thyristor and the attached field effect transistor structure can be designed separately and independently.

The document FR-A-2 486 046 discloses a thyristor which is coupled to a DMOS-FET to form the Darlington-circuit. This combined thyristor cannot be turned off.

The invention relates to an insulated gate rectifier semiconductordevice, and, more particularly, to such a device having an improved capability for carrying current without "latching on", or becoming established in a current-carrying state.

An insulated gate recitifier (IGR) is a semiconductor device having a "gate" or control electrode for controlling current flow therein between its main electrodes (i.e., its anode and cathode). Prior art IGRs are described in detail (and claimed) in the above- referenced application, Serial No. 212,181.

Atypical IGR inherently includes a parasitic P-N-P-N structure. The IGR can function properly as long as the P-N-P-N structure does not latch on. If this structure latches on, however, control of current in the IGR by its control electrode is totally lost.

The present inventors have discovered the reason for latching on of a parasitic P-N-P-N structure in a prior art IGR. The reason is that hole current exists within the IGR's P-type region which is proximate the IGR's control electrode, and into which a N-type region is formed by diffusion or ion implanting. The whole current causes a voltage drop within a P-type region. This voltage drop can become so large that the P-N junction between the P-type region and the N-type region become excessively forward biased, or biased into a state in which the parasitic P-N-P-N structure latches on. It would thus be desirable to provide an IGR which is less susceptible of latching on.

Accordingly, an object of the invention is to provide an insulated gate rectifier having a greatly diminished risk of latching on than is the case with prior art insulated gate rectifiers and an improved current-carrying capability without latching on, using reliable, existing processing techniques and with a low threshold voltage level for its control electrode.

This problem is solved according to the invention by the features of the characterizing part of claim 1.

Thus, according to the invention, there is provided an improved insulated gate rectifier comprising a semiconductor body having an upper surface, said semiconductor body including first, second, third and fourth regions of alternate conductivity, said second region adjoining said first region, said third region being embedded in said second region, said fourth region in turn being embedded in said third region, a first electrode adjoining said first region, a second electrode adjoining an upper surface portion of said third region, an upper surface portion of said fourth region and of a P-N-junction formed between these two regions, a gate control electrode spaced from said body by an insulating layer and overlying an upper surface portion of said second region and completely overlying a first portion of said third region, said first portion containing an inversion channel, and a second portion of said third region being of lower resistivity than said first portion, the doping concentration of said second portion being at least about an order of magnitude higher than the doping concentration of the first portion, said second portion having a substantially greater depth, measured from the upper surface, than said first portion, characterized in that said first portion of said third region has a doping concentration of 1017 - 5 X ¹⁸ dopant atoms per cubic centimeter and a depth of 2 wm, said second portion of the third region has a doping concentration of about 10¹⁹ dopant atoms per cubic centimeter and a depth of 5 wm, and said fourth region has a doping concentration greater than 10¹⁹ dopant atoms per cubic centimeter and a depth of 1 wm, whereby the resistance of said second portion is kept below a value which would cause the P-N-junction to become forward biased to an extent sufficient to cause injection of electrons into said third region so as to cause the device to latch-on.

The invention is further described in conjunction with the accompanying drawing figures, in which:
Figure 1 is a schematic, cros-sectional view of a prior art insulated gate rectifier; and
Figure 2 is a schematic, cross-sectional view of an insulated gate rectifier incorporating the improvement of the present invention.

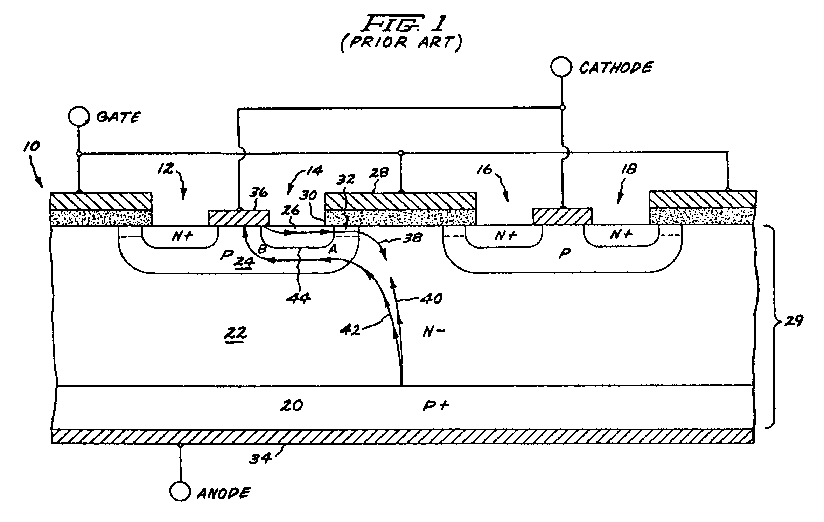

The phenomenon of latching on of a parasitic P-N-P-N structure in an insulated gate rectifier (IGR) can be understood in detail, with reference to Figure 1, which illustrates a prior art IGR 10.

The IGR 10 comprises a plurality of cells-for example, cells 12, 14, 16 and 18. An understanding of latching on of one cell, such as cell 14, yields an understanding of latching on of the IGR 10 because each cell operates in the same fashion.

The IGR cell 14 comprises a P-type region 20, an N-type region 22, a P-type region 24, and an N-type region 26. These regions form a parasitic P-N-P-N structure. The cell 14 further includes a gate or control electrode 28 spaced from the IGR semiconductor body 29 by an insulating layer 30 and which overlies the P-type region 24, an anode 34, and a cathode 36.

Upon biasing of the gate 28 with a positive voltage above a threshold value, a portion of the P-type region 24 adjacent to the insulating layer 30 becomes "inverted" or more populated by electrons (minority carriers) than holes (majority carriers), forming in such region an inversion channel 32 which can conduct electrons. The inversion channel 32 serves as a "floodgate', enabling a level of electron current, controlled by the intensity of voltage on the gate 28, to flow from the cathode 36 to the N-type region 22, via an electron current path 38. Meanwhile, the P-type region 20 injects holes into the N-type region 22, some of which follow a hole current path 40. Electrons from the electron current path 38 recombine with holes from the hole current path 40 to form the bulk of the IGR 10 current. However, as discovered by the present inventors, a portion of the holes injected into the N-type region 22 from the P-type region 20 enter into the P-type region 24 through a hole current path 42, and continue to flow to the cathode 36 (where they recombine with electrons from the cathode 36). Holes flowing in the hole current path 42 within the P-type region 24 cause a voltage drop between locations A and B along P-N junction 44 between the P-type region 24 and the N-type region 26. The higher the level of hole current in the hole current path 42, the higher the voltage drop between locations A and B. The IGR 10 can operate properly as long as this voltage drop is maintained below a value which would cause junction 44 to become excessively forward biased.

Excessive forward biasing of the junction 44 causes the parasitic P-N-P-N structure to latch on, with attendant, complete loss of control of the IGR 10 current by the gate 28. Inasmuch as the hole current in the hole current path 42 decreases with decreasing IGR 10 current, the IGR 10 can properly function along as its maximum current is limited to a value which insures that the voltage drop between locations A and B does not excessively forward bias the junction 44. This, however, underutilizes the current-carrying potential of the IGR 10.

The present inventors have found that the current-carrying capability of the prior art IGR 10 can be increased by decreasing the resistance in the P-type region 24 between locations A and B. One technique of doing this is to decrease the lateral width of the N-type region 26 (as viewed in Figure 1); however, this technique is limited by the state-of-the-art in lithog- raphywhich determines how narrow region, such as the N-type region 26, can be made. A second approach is to dope more heavily the P-type region 24 to decreas its resistivity; however, this undesirably raises the threshold level of the voltage on the gate 28 necessary to form the inversion channel 32. Thirdly, the depth of the P-type region 24 (the vertical dimension in Figure 1) can be increased; however, this results in an increase in width of the P-type region 24, whether it is formed by diffusion or ion implantation, thereby lengthening the inversion channel 32 so as to increase its resistance. Increased resistance of the channel 32 results in an undesirably larger forward voltage drop across the IGR 10.

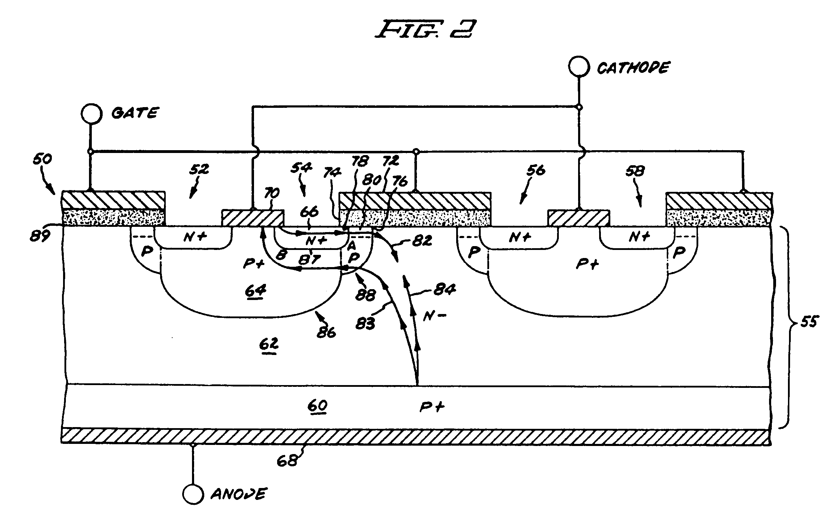

An improved IGR 50 in accordance with the present invention is shown in Figure 2. The IGR 50 includes cells 52 and 54, which are suitably symmetrical to each other, and cells 56 and 58 which correspond in structure and function to the cells 52 and 54, respectively. Accordingly, only the cell 54 is described in detail below.

The IGR 50 includes a semiconductor body 55, preferably fabricated of silicon, and includes a first (P-type) region 60, a second (N-type) region 62, a third (P-type) region 64 and a fourth (N-type) region 66, these regions forming a parasitic P-N-P-N structure. The IGR cell 54 further includes an anode 68 adjoining the P-type region 60, a cathode 70 adjoining both the P-type region 64 and the N-type region 66, and a gate or control electrode 72 spaced from the IGR semiconductor body 55 by an insulating layer 74. The gate 72 overlies the P-type region 64 from a location 76 proximate the second region 62 to a location 78 proximate the N-type region 66.

When the gate 72 is biased with a positive voltage above a threshold level, the portion of the P-type region 64 adjacent to the insulating layer 74 becomes inverted, creating an inversion channel 80 which conducts electrons. The inversion channel 80 completes an electron current path 82 between the cathode 70 and the N-type region 62. The P-type region 60 injects holes into the N-type region 62. A portion of these holes flow in a hole current path 84, and recombine with electrons from the electron current path 82; a further portion of these holes flow in a hole current path 83 into and through the P-type region 64 to the cathode 70 (where the holes recombine with the electrons from the cathode 70).

The flow of holes in the hole current path 83 within the P-type region 64 results in a reduced voltage drop between locations A and B in the IGR 50 as compared with the corresponding voltage drop in the prior art IGR 10 of Figure 1. This is due to the modified P-type region 64. The region 64 comprises portions 86 and 88. The portion 88 is adjacent to the insulating layer 74 and contains the inversion channel 80. The portion 86 extends from cathode 70 and has a substantially higher doping concentration than the portion 88 (discussed further below), and thus has a lower resistivity to holes than the portion 88. The portion 86 has a substantially greater depth (measured in Figure 2 from the upper surface 89 of the semiconductor body 55) than the portion 88. In the preferred embodiment (1) the IGR semiconductor body 55 comprises a wafer, (2) the insulating layer 74 is generally planer, and (3) the P-type portions 86 and 88 and N-type region 66 each comprises a region diffused through the upper major surface 89 of the body 55. By way of example, the portion 86 typically has a depth of 5 µm (microns); the portion 88, a depth of 2 µm (microns); and the N-type region 66, a depth of 1 µm (micron).

Typical doping concentrations (that is, the number of dopant atoms per cubic centimeter) for the various regions of the IGR 50 are in the order of the following numbers:
The first region 60: 1019;
The second region 62: 10¹⁴ to 5x1 015;
The P-type portion 88: 10¹⁷ to 5x1 018;
The P-type portion 86: 10¹⁹; and
The N-type region 66: greater than 10¹⁹.

It will thus be recognized that the P-type portion 86 has a dopant concentration substantially higher than the doping concentration of the P-type portion 88, where "substantially higher" means higher by at least about an order of magnitude.

It has been found that the preferred embodiment of the IGR 50 can operate without latching on at a current level about an order of magnitude higher than the prior art IGR 10, at least where the IGRs 10 and 50 are substantially alike, except for the inclusion of the portion 86 in the IGR 50.

The preferred embodiment of the IGR 50 also avoids the deficiencies of the above-mentioned other techniques for decreasing the resistance between locations A and B in the P-type region 24 of the prior art IGR 10. In particular, the improved IGR 50 can be fabricated using the reliable, existing techniques of planar diffusion. Additionally, in the improved IGR 50, the portion 88 of the P-type region 64 containing the inversion channel 80 can be identical to the portion of the P-type region 24 of the prior art IGR 10 containing the inversion channel 32. Thus, neither the threshold voltage level on the gate 72 of the IGR 50, for forming the inversion channel 80, nor the forward voltage drop across the IGR 50 is undesirably increased above the corresponding values for the prior art IGR 10.

While the invention has been described with respect to specific embodiments by way of illustration, many modifications and changes will occur to those skilled in the art. For example, complementary IGRs could be made wherein the foregoing description of the invention would be applicable if P-type material were considered instead of N-type material, and vice-versa, and holes were considered instead of electrons, and vice-versa. Further, the portions 86 and 88 of the P-type region 64 and the N-type region 66 could be introduced through the upper surface 89 of the semiconductor body 55 by the technique of ion implantation, as an alternative to diffusion. Additionally, the N-type region 62 could be modified to have its portion in contact with the P-type region 60 doped to a higher concentration than its portion intermediate the P-type regions 60 and 64, which intermediate portion would still have a typical doping concentration as specified above; moreover, the P-type region 60 could be modified to have its portion in contact with the N-type region 62 doped to a higher concentration than its major portion, which major portion would still have the typical doping concentration specified above.

## Claims

1. An insulated gate rectifier (IGR) comprising:
a semiconductor body (55) having an upper surface (89), said semiconductor body (55) including first (60), second (62), third (64) and fourth (66) regions of alternate conductivity (P resp. N), said second region (62) adjoining said first region (60), said third region (64) being embedded in said second region (62), said fourth region (66) in turn being embedded in said third region (64),
a first electrode (68) adjoining said first region (60),
a second electrode (70) adjoining an upper surface portion of said third region (64), an upper surface portion of said fourth region (66) and of a P-N-junction (87) formed between these two regions,
a gate control electrode (72) spaced from said body (55) by an insulating layer (74) and overlying an upper surface portion of said second region (62) and completely overlying a first portion (88) of said third region (64), said first portion (88) containing an inversion channel (80), and
a second portion (86) of said third region (64) being of lower resistivity than said first portion (88), the doping concentration of said second portion (86) being at least about an order of magnitude higher than the doping concentration of the first portion (88), said second portion (86) having a substantially greater depth, measured from the upper surface (89), than said first portion (88),
characterized in that
said first portion (88) of said third region (64) has a doping concentration of 1 017 - 5 x ¹⁸ dopant atoms per cubic centimeter and a depth of 2 wm, said second portion (86) of the third region (64) has a doping concentration of about 10¹⁹ dopant atoms per cubic centimeter and a depth of 5 µm and said fourth region (66) has a doping concentration greaterthan 10¹⁹ dopant atoms per cubic centimeter and a depth of 1 wm, whereby the resistance of said second portion (86) is kept below a value which would cause the P-N-junction (87) to become forward biased to an extent sufficient to cause injection of electrons into said third region (64) so as to cause the device to latch-on.

2. A rectifier according to claim 1, characterized in that said insulating layer (74) is generally planar.

3. A rectifier according to claim 1 or 2, characterized in that said semiconductor body (55) comprises a wafer of semiconductor material.

4. A rectifier according to claim 3, characterized in that said first electrode (68) adjoins a first major surface of said wafer and said second electrode (70) adjoins a second major surface of said wafer.

5. A rectifier according to claim 3 or 4, characterized in that said wafer of semiconductor material comprises silicon.

6. A rectifier according to any one of the preceding claims, characterized in that said first region (60) is of P-type conductivity.

## Patentansprüche

1. Gleichrichter mit isolierter Steuerelektrode (IGR), mit
einem Halbleiterkörper (55) mit einer oberen Oberfläche (89), wobei der Halbleiterkörper (55) einen ersten (60), einen zweiten (62), einen dritten (64) und einen vierten (66) Bereich aufweist, deren Leitfähigkeit (p- bzw. n-Leitfähigkeit) abwechselt, wobei der zweite Bereich (62) an den ersten Bereich (60) angrenzt, der dritte Bereich (64) in dem zweiten Bereich (62) eingebettet ist und der vierte Bereich (66) seinerseits in dem dritten Bereich (64) eingebettet ist,
einer ersten Elektrode (68), die an den ersten Bereich (60) angrenzt,
einer zweiten Elektrode (70), die an einen oberen Oberflächenteil des dritten Bereichs (64) und an einen oberen Oberflächenteil des vierten Bereichs (66) und eines zwischen diesen zwei Bereichen gebildeten pn-Übergangs (87) angrenzt, und
einer Gate-Steuerelektrode (72), die durch eine isolierende Schicht (74) in einem Abstand von dem Körper (55) gehalten wird und über einem oberen Oberflächenteil des zweiten Bereichs (62) und vollständig über einem ersten Teil (88) des dritten Bereichs (64) liegt, und der erste Teil (88) einen Inversionskanal (80) aufweist, und
wobei ein zweiter Teil (86) des dritten Bereichs (64) einen niedrigeren spezifischen Widerstand als der erste Teil (88) aufweist und die Störstellenkonzentration des zweiten Teils (86) wenigstens etwa eine Größenordnung höher ist als die Störstellenkonzentration des ersten Teils (88), und der zweite Teil (86) eine wesentlich größere Tiefe, gemessen von der oberen Oberfläche (89) aus, als der erste Teil (88) aufweist,
dadurch gekennzeichnet, daß
der erste Teil (88) des dritten Bereichs (64) eine Störstellenkonzentration von 10¹⁷ bis 5 x 1018 Fremdatomen/cm³ und eine Tiefe von 2 µm aufweist, der zweite Teil (86) des dritten Bereichs (64) eine Störstellenkonzentration von etwa 10¹⁹ Fremdatomen/cm₃ und eine Tiefe von 5 µm aufweist, und der vierte Bereich (66) eine Störstellenkonzentration von mehr als 10¹⁹ Fremdato- men/cm₃ und eine Tiefe von 1 µm aufweist, und wobei der spezifische Widerstand des zweiten Teils (86) unter einem Wert gehalten wird, bei dem der pn-Übergang (87) in Vorwärtsrichtung bis zu einem ausreichenden Grad vorgespannt wird, wodurch das Injizieren von Elektronen in den dritten Bereich (64) und damit das Durchschalten des Gleichrichters bewirkt wird.

2. Gleichrichter nach Anspruch 1, dadurch gekennzeichnet, daß die isolierende Schicht (74) im allgemeinen planar ist.

3. Gleichrichter nach Anspruch 1 oder 2, dadurch gekennzeichnet, daß der Halbleiterkörper (55) aus einem Wafer aus Halbleitermaterial besteht.

4. Gleichrichter nach Anspruch 3, dadurch gekennzeichnet, daß die erste Elektrode (68) an eine erste Hauptoberfläche des Wafers und die zweite Elektrode (70) an eine zweite Hauptoberfläche des Wafers angrenzt.

5. Gleichrichter nach Anspruch 3 oder 4, dadurch gekennzeichnet, daß der Wafer aus Halbleitermaterial Silicium enthält.

6. Gleichrichter nach einem der vorhergehenden Ansprüche, dadurch gekennzeichnet, daß der erste Bereich (60) p-Leitfähigkeit aufweist.

## Revendications

1. Redresseur à grille isolée (IGR) qui comporte :
un corps semi-conducteur (55) ayant une surface supérieure (89), ledit corps semi-conducteur (55) comprenant des première (60), seconde (62), troisième (64) et quatrième (66) régions de conductivité alternée (respectivement P et N), ladite seconde région (62) étant contiguë à ladite première région (60), ladite troisième région (64) étant enterrée dans ladite seconde région (62), ladite quatrième région (66) étant à son tour enterrée dans ladite troisième région (64),
une première électrode (68) contiguë à ladite première région (60),
une seconde électrode (70) contiguë à une partie de la surface supérieure de ladite troisième région (64), à une partie de la surface supérieure de ladite quatrième région (66) et d'une jonction P-N (87) qui est formée entre ces deux régions,
une électrode de commande de grille (72), qui est séparée dudit corps (55) par une couche d'isolation (74), qui recouvre une partie de la surface supérieure de ladite seconde région (62), et qui recouvre complètement une première partie (88) de ladite troisième région (64), ladite première partie (88) contenant un canal d'inversion (80), et
une seconde partie (86) de ladite troisième région (64) ayant une résistivité inférieure à celle de ladite première partie (88), la concentration de dopage de ladite seconde partie (86) étant supérieure d'un ordre de grandeur au moins à la concentration de dopage de ladite première partie (88), ladite seconde partie (86) ayant une profondeur, mesurée à partir de la surface supérieure (89), notablement supérieure à celle de ladite première partie (88),
caractérisé en ce que ladite première partie (88) de ladite troisième région (64) présente une concentration de dopage de 10^{17 -} 5 x 10¹⁸ atomes dopants par cm³ et une profondeur de 2 wm, ladite seconde partie (86) de la troisième région (64) présente une concentration de dopage d'environ 10¹⁹ atomes dopants par cm³ et une profondeur de 5 wm, et ladite quatrième région (66) présente une concentration de dopage supérieure à 10¹⁹ atomes dopants par cm³ et une profondeur de 1 wm, ce qui fait que la résistance de ladite seconde partie (86) est maintenue en-dessous d'une valeur qui amènerait la jonction P-N (87) à devenir suffisamment polarisée en direct pour provoquer une injection d'électrons dans ladite troisième région (64) de façon à provoquer le verrouillage du dispositif à l'état conducteur.

2. Redresseur selon la revendication 1, caractérisé en ce que ladite couche d'isolation (74) est globalement plane.

3. Redresseur selon la revendication 1 ou 2, caractérisé en ce que ledit corps semi-conducteur (55) comporte une pastille de matériau semi-conducteur.

4. Redresseur selon la revendication 3, caractérisé en ce que ladite première électrode (68) est contiguë à une première surface principale de ladite pastille et ladite seconde électrode (70) est contiguë à une seconde surface principale de ladite pastille.

5. Redresseur selon la revendication 3 ou 4, caractérisé en ce que ladite pastille de matériau semi-conducteur contient du silicium.

6. Redresseur selon l'une quelconque des revendications précédentes, caractérisé en ce que ladite première région (60) a une conductivité du type P.
